(19) Europäisches Patentamt
European Patent Office
Office européen des brevets

(11) **EP 1 562 216 B1**

(12) **EUROPEAN PATENT SPECIFICATION**

(45) Date of publication and mention of the grant of the patent:
**10.11.2010 Bulletin 2010/45**

(51) Int Cl.:
***H01J 17/28*** (2006.01)    ***H01J 17/49*** (2006.01)

(21) Application number: **05090017.4**

(22) Date of filing: **02.02.2005**

(54) **Chassis assembly for plasma display apparatus and plasma display apparatus having the same**

Gestell für Plasma Anzeigetafel und Plasma Anzeigetafel

Châssis pour écran à plasma et écran à plasma

(84) Designated Contracting States:
**DE FR GB**

(30) Priority: **09.02.2004  KR 2004008256**
        **18.11.2004  KR 2004094428**
        **30.12.2004  KR 2004116917**

(43) Date of publication of application:
**10.08.2005  Bulletin 2005/32**

(73) Proprietor: **Samsung SDI Co., Ltd.**
**Suwon-si,**
**Gyeonggi-do (KR)**

(72) Inventors:
 • **Kang, Tae-Kyoung**
 **Legal&IP Team, Samsung SDI Co., Ltd**
 **Gyeonggi-do (KR)**
 • **Kim Sok- San**
 **Cheonan-si, Chungcheongnam-do (KR)**

 • **Kim, Dong-Hwan,**
 **110-1306 Dongsuwon LG  Village**
 **Suwon-si, Gyeonggi-do (KR)**
 • **Cho, In-Soo**
 **Seongnam-si, Gyeonggi-do (KR)**
 • **Ahn, Joong-Ha,**
 **103-1303 Hyundai 1cha I-Park**
 **Suwon-si, Gyeonggi-do (KR)**

(74) Representative: **Hengelhaupt, Jürgen et al**
**Gulde Hengelhaupt Ziebig & Schneider**
**Patentanwälte - Rechtsanwälte**
**Wallstrasse 58/59**
**10179 Berlin (DE)**

(56) References cited:
**EP-A2- 0 821 385        WO-A2-2004/013885**
**US-A1- 2002 043 607    US-A1- 2002 195 937**
**US-A1- 2003 102 789    US-A1- 2004 257 307**

**Description**

## BACKGROUND OF THE INVENTION

### Field of the Invention

The present invention relates to a chassis assembly for a plasma display apparatus and a plasma display apparatus having the same, and more particularly, to a chassis assembly to reduce a discharge delay in a plasma display apparatus and a plasma display apparatus having the same.

### Description of the Background

A plasma display apparatus is a flat panel display apparatus that forms a high-quality image using a gaseous discharge. It is lightweight, it may have a large screen and wide view-angle, and it may be manufactured in an ultra-slim size. The plasma display apparatus may be easier to manufacture than other flat panel display apparatuses, and its size may be easily increased.

Since a plasma display panel (PDP) included in the plasma display apparatus displays an image by an internal gaseous discharge, it may generate a lot of heat when driven. If not properly dissipated, the heat may permanently bum an image into the PDP. Thus, in order to prevent this problem, in general, the heat generated in the PDP is dissipated through a chassis disposed at a rear side of the PDP. The chassis is typically manufactured using aluminum, which has a thermal conductivity of about 150 - 220 W/mK.

When the chassis is manufactured using a material having high thermal conductivity, it may dissipate a lot of heat. However, when PDP operates in a low temperature environment, the temperature of the PDP's discharge gas may decrease, thereby causing a plasma discharge delay. Here, discharge delay means that the plasma discharge in discharge cells is not performed in a required time.

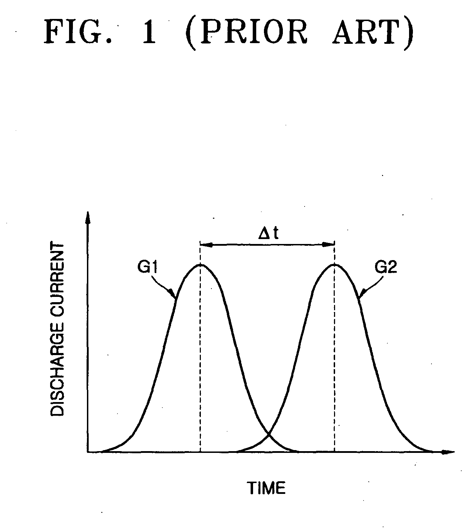

FIG. 1 is a schematic graph showing a discharge delay, where the horizontal axis represents time, and the vertical axis represents the size of a discharge current. Referring to FIG. 1, a discharge current required in one discharge cell has a first curve G1. However, when a discharge delay occurs, the discharge current has a second curve G2 that is delayed by a time $\Delta t$. As excessive heat dissipation lowers the discharge gas temperature, the discharge delay may increase. US 2002/195937 discloses the use of a heat dissipation plate for a plasma display device having a thermal conductivity in a range of about 10 W/mK to about 100 W/mK. Furthermore, US 2002/043607 and WO 2004/013885 disclose a supporting plate (or chassis) for a flat panel display comprising iron.

## SUMMARY OF THE INVENTION

The present invention provides a chassis assembly that may reduce a discharge delay in a plasma display apparatus and a plasma display apparatus having the same.

The present invention discloses a chassis assembly for a plasma display apparatus. The chassis assembly comprises a chassis having a thermal conductivity in a range of about 10 W/mK to about 100 W/mK. The chassis is formed of a material containing galvanized iron. A reinforcement member is coupled to the chassis and the reinforcement member is formed of a same material forming the chassis. The chassis and the reinforcement member are formed as a single body.

The present invention also discloses a plasma display apparatus comprising a plasma display panel that displays an image using a gaseous discharge, and a chassis supporting the plasma display panel. The chassis has a thermal conductivity in a range of about 10 W/mK to about 100 W/mK. The chassis is formed of a material containing galvanized iron. A reinforcement member is coupled to the chassis and the reinforcement member is formed of a same material forming the chassis. The chassis and the reinforcement member are formed as a single body.

It is to be understood that both the foregoing general description and the following detailed description are exemplary and explanatory and are intended to provide further explanation of the invention as claimed.

## BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

FIG. 1 is a graph showing a discharge delay of a conventional plasma display apparatus.

FIG. 2 is an exploded perspective view showing a plasma display apparatus according to an exemplary embodiment of the present invention.

FIG. 3 is a partial cut and exploded perspective view showing a PDP of FIG. 2.

FIG. 4 is a graph showing an address voltage and discharge current versus time.

FIG. 5 is a graph showing a discharge delay time versus chassis thermal conductivity.

## DETAILED DESCRIPTION OF THE ILLUSTRATED EMBODIMENTS

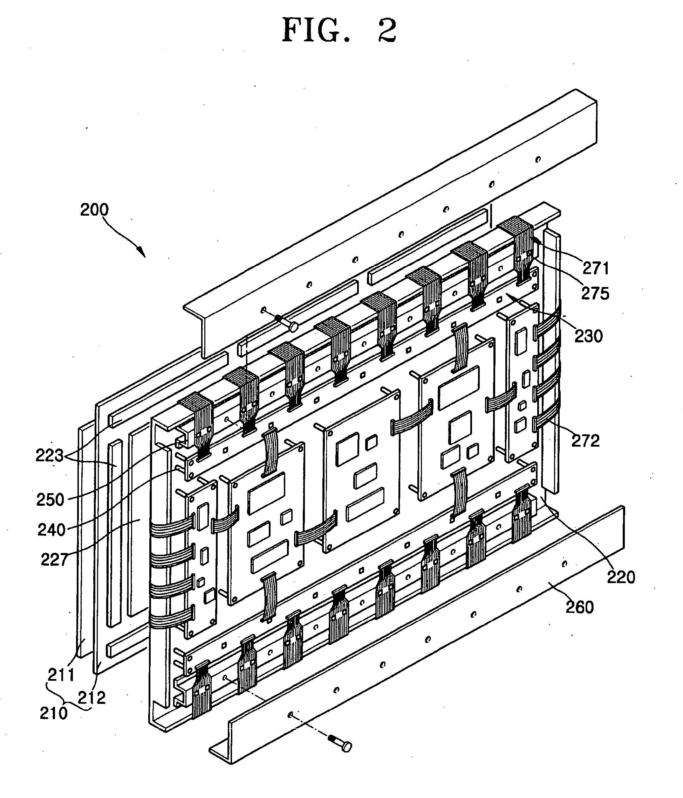

FIG. 2 is an exploded perspective view showing a plasma display apparatus 200 according to an exemplary embodiment of the present invention. Referring to FIG. 2, the plasma display apparatus 200 may include a chassis assembly having a chassis 220, reinforcement members 250, a PDP 210, which is supported in front of the chassis 220 and forms an image using a gas discharge, and circuits 230, which are coupled to the rear of the chassis 220 and drive the PDP 210.

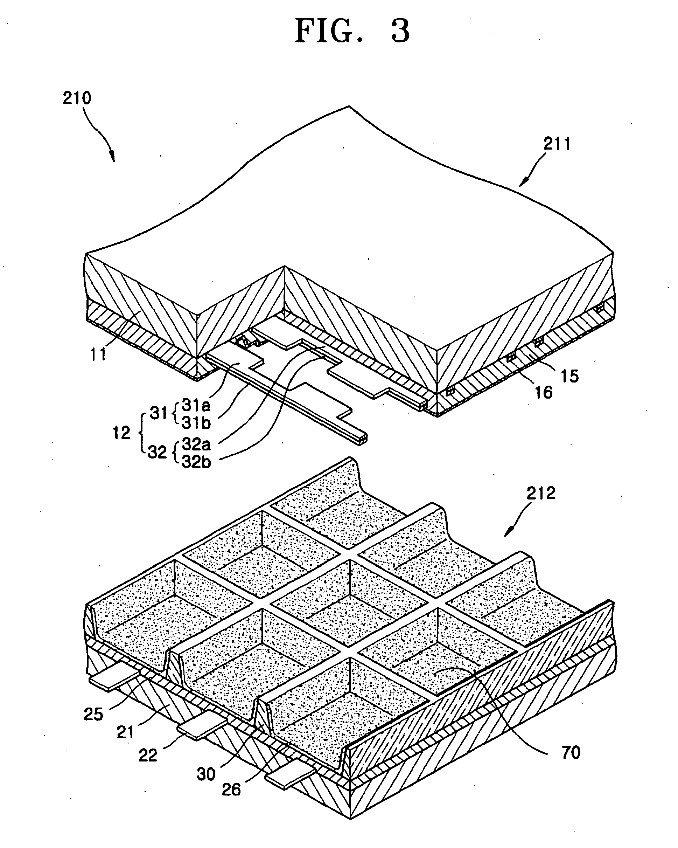

FIG. 3 is a partial cut and exploded perspective view showing a triode surface-discharge AC PDP 210 as an example of the PDP shown in FIG. 2. Referring to FIG. 3, the PDP 210 may include an upper plate 211 and a lower plate 212 in parallel to each other. Sustain electrodes 12 may be disposed on a front surface of a front substrate 11. In this case, since an image may be viewed through the front substrate 11, it may be formed of a transparent material. The sustain electrode 12 may include a scan electrode 31 and a common electrode 32 pair in parallel to each other. The scan electrode 31 and the common electrode 32 may include transparent electrodes 31a and 32a and bus electrodes 31b and 32b, respectively. The transparent electrodes 31a and 32a may be formed of a conductive transparent material, such as indium tin oxide (ITO), because light emitted from a phosphor layer 26 travels toward the front substrate 11. However, the transparent conductive material may have a large resistance. Thus, when sustain electrodes include only the transparent electrodes, they may have a large voltage drop in a lengthwise direction, thereby consuming much driving power and reducing a response speed. In order to solve this problem, metallic bus electrodes 31b and 32b may be coupled to the transparent electrodes. Address electrodes 22 may be disposed on a surface of a rear substrate 21 that faces the front substrate 11, to cross the scan electrodes 31 and the common electrodes 32 in unit discharge cells 70. The address electrodes 22 may be used to cause an address discharge, which facilitates a sustain discharge between the scan and common electrodes. More specifically, the address electrodes 22 may reduce a voltage required for the sustain discharge. The address discharge may occur between a scan electrode 31 and an address electrode 22, and it may provide positive ions on the scan electrode 31 and electrons on the common electrode 32. The unit discharge cell 70 is formed by the scan and common electrode pair, and the address electrode that crosses the pair. A front dielectric layer 15 covers the sustain electrodes 12, and it may be formed of a transparent dielectric material. The front dielectric layer 15 prevents an electric short between adjacent scan electrodes 31 and common electrodes 32 during a main discharge, and it prevents damage to the sustain electrodes from collisions with positive ions or electrons. The front dielectric layer 15 may accumulate wall charges by inducing charges. The dielectric material may be PbO, $B_2O_3$, or $SiO_2$. Additionally, a protective layer 16, which may be formed of MgO, may cover the front dielectric layer 15. The protective layer 16 prevents damage to the front dielectric layer 15 from collisions with positive ions and electrons during a discharge. The protective layer 16 may be transparent, and it may emit a large amount of secondary electrons during the discharge. A rear dielectric layer 25 covers the address electrodes 22. Barrier ribs 30 may be formed on the rear dielectric layer 25 to maintain a discharge distance and prevent electrical and optical cross-talk between discharge cells. Phosphor layers 26, which may produce red, green, and blue light, may be coated on both sides of the barrier ribs 30 and the front surface of the rear dielectric layer 25. The present invention is not limited to the exemplary structure of the PDP shown in FIG. 3.

The operation of the PDP 210 having the above structure will now be described.

Plasma discharges occurring in the PDP 210 may include an address discharge and a sustain discharge. The address discharge may occur when an address-discharge voltage is applied between the address electrode 22 and the scan electrode 31, thereby selecting a discharge cell 70 in which the sustain discharge will occur. More specifically, applying a scan pulse to the scan electrode 31 and an address pulse to the address electrode 22 generates an address-discharge voltage between them. Next, when a sustain voltage is alternately applied between the scan electrode 31 and the common electrode 32 of the selected discharge cell 70, particles accumulated on the scan and common electrodes collide with one another so that the sustain discharge occurs. When an energy level of a discharge gas excited during the sustain discharge decreases, ultraviolet rays are emitted. The ultraviolet rays excite the phosphor layer 26, and when an energy level of the excited phosphor layer 26 decreases, visible light is emitted, which forms an image.

When driving the PDP 210 in this manner, the plasma discharges may generate a lot of heat. If not properly dissipated, the heat may cause images to be burned into the PDP 210. Thus, the chassis 220, which supports the PDP 210 and serves as a dissipation member, may be coupled to the rear of the PDP. In light of size and weight considerations, the thickness of the chassis 220 may be in a range of about 0.8 to about 2.0 mm.

Additionally, a thermal conductive medium 227 may be interposed between the PDP 210 and the chassis 220. The thermal conductive medium 227 removes local thermal concentration by dispersing the heat generated in the PDP and transmitting it to the chassis 220. In the present exemplary embodiment, the thermal conductive medium 227 is a single sheet. One of its sides may be attached to the PDP 210, and the other may be attached to the chassis 220. However, the shape and interposing method of the thermal conductive medium 227 is not limited to this. It may be formed as a plurality of sheets, and it may be separated from the chassis 220. In order to improve thermal conductivity, the thermal conductive medium 227 may be formed of a material containing carbon groups, such as graphite, having high thermal conductivity, or silicon.

In the present exemplary embodiment, the PDP 210 and the chassis 220 may be coupled together using double sided adhesive tape 223. The double sided adhesive tape 223 may surround the thermal conductive medium 227.

Circuits 230 that drive the PDP 210 may be separated from a rear side of the chassis 220 by bosses 240. Generally, screws, inserted into the bosses 240 via a through hole of the circuits 230, may couple the circuits 230 to the chassis 220.

A signal transmitting unit may couple the PDP 210 to the circuits 230 in order to transmit electrical signals and power between them. In the present exemplary embodiment, the signal transmitting unit comprises a flexible printed circuit (FPC) 272 and a tape carrier package (TCP) 271. In particular, the TCP 271, having a mounted electronic element 275, may couple an address driving part of the circuits 230 to the address electrodes 22 of the PDP 210. A cover plate 260 covers the TCP 271 and dissipates heat generated in the electronic element 275. Additionally, a thermal conductive sheet (not shown) may be inserted between the TCP 271 and the cover plate 260, and a grease (not shown) may be inserted between the TCP 271 and the reinforcement members 250 so as to quicken heat transfer and reduce a compressive force applied to the electronic element 275.

The reinforcement members 250 may be coupled to a rear side of the chassis 220 strengthen the chassis 220. Screws (not shown) may be used to couple the reinforcement members and the chassis together. The reinforcement members 250 may not overlap with the circuits 230, and they may be disposed at a portion of the chassis where cable and circuit boards are not installed. The reinforcement members 250 may have L-shaped or U-shaped cross sections, and they may be manufactured and combined separately from the chassis 220. However, in order to simplify a manufacturing process, the chassis 220 and the reinforcement members 250 may be formed as a single body. Additionally, in order to prevent bending caused by their different thermal expansion coefficients, the chassis 220 and the reinforcement members 250 may be formed of the same material.

As described above, when heat generated in the PDP 210 is dissipated during driving, if it is excessively dissipated, a discharge delay may occur in the PDP. In other words, a discharge may not occur in the discharge cells 70 during a desired time. Thus, the chassis 220 may be formed of a material that maintains an appropriate internal temperature of the PDP 210.

When driving the PDP 210 using an address-display separation (ADS) driving method, a discharge delay may occur in an address-discharge period and a sustain-discharge period. In the sustain-discharge period, a plurality of sustain-discharge pulses may be alternately applied to the scan and common electrodes 31 and 32 of a discharge cell 70. In the address-discharge period, one scan pulse and an address pulse may be applied to the scan electrode 31 and the address electrode 22 in one discharge cell 70. Thus, a discharge delay occurring in the address-discharge period may be more problematic than a discharge delay occurring in the sustain-discharge period.

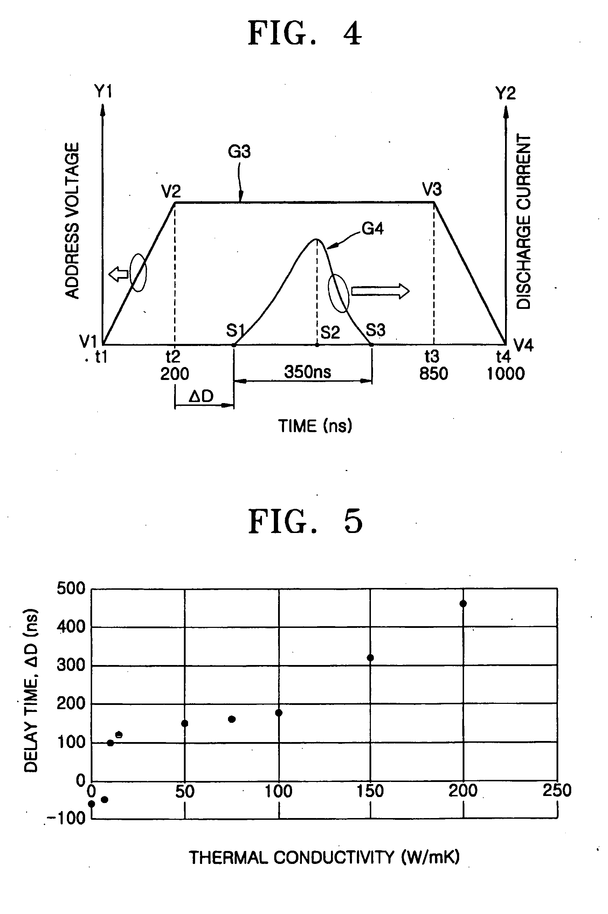

FIG. 4 is a schematic graph showing an address voltage G3 and discharge current G4 versus time when one address pulse is applied to the address electrode 22 in an address-discharge period. In the graph of FIG. 4, the horizontal axis represents time in nanoseconds (ns), the left vertical axis Y1 represents an address voltage, and the right vertical axis Y2 represents a discharge current.

As shown in FIG. 4, between a first time t1 and a second time t2, the address voltage increases from a first voltage V1 to a second voltage V2, and between the second time t2 and a third time t3, the address voltage maintains a voltage V2 = V3. Then, between the third time t3 and a fourth time t4, the address voltage decreases to a fourth voltage V4, which may equal the first voltage V1.

One pulse may be applied to the address electrodes 22 during a time interval from the first time t1 to the fourth time t4, which may be 1000 ns. In this case, a time interval between the first time t1 and the second time t2 is 200 ns, a time interval between the second time t2 and the third time t3 is 650 ns, and a time interval between the third time t3 and the fourth time t4 is 150 ns.

A discharge current during an address discharge is generated at a first discharge time S1, it has a maximum value at a second discharge time S2, and it is extinguished at a third discharge time S3. Additionally, a duration time of the discharge current may be about 350 ns, which is the time between the first discharge time S1 and the third discharge time S3.

Placing the discharge current G4 between the second time t2 and the third time t3 may provide a stable address discharge. Thus, of the 650 ns between the second time t2 and the third time t3, about 350 ns may be required for the discharge current. Therefore, a discharge delay time ΔD should be below 300 ns. In light of this, the chassis 220 may be formed of a material in which a delay time ΔD between the first discharge time S1 and the second time t2 is maintained below 300 ns.

Table 1 shows experimental results of the delay time ΔD versus different values of chassis thermal conductivity, and FIG. 5 is a graph obtained using the experimental values of Table 1. The experiment was performed by installing a 42-inch PDP 210 in a chamber having a temperature of -30°C. In this case, the chassis 220 was 2 mm thick, and a 1.4 mm thick carbon sheet was used as the thermal conductive medium 227. The experimental values were measured when the PDP 210 was operated in a steady state.

Table 1

| Thermal conductivity | 0.02 | 7 | 10 | 15 | 50 | 75 | 100 | 150 | 200 |
|---|---|---|---|---|---|---|---|---|---|
| Delay time | -60 | -50 | 100 | 120 | 150 | 160 | 175 | 320 | 460 |

As Table 1 shows, as the thermal conductivity of the chassis 220 increases, the delay time $\Delta D$ increases. If the thermal conductivity of the chassis 220 increases, heat may dissipate more rapidly from the PDP, the PDP's temperature may stay low, and the delay time $\Delta D$ may increase. Here, a negative delay time $\Delta D$ indicates that the first discharge time S1 occurs earlier than the second time t2, which means the PDP is overcharged. This may occur when the chassis' thermal conductivity is too low and heat generated in the PDP is not effectively dissipated, thus resulting in the PDP's internal temperature rising above an appropriate value.

Referring to FIG. 5, since the delay time $\Delta D$ between the first discharge time S1 and the second time t2 should be between 0 ns and 300 ns, the thermal conductivity of the chassis may be less than or equal to about 100 W/mK. In particular, when the thermal conductivity of the chassis exceeds 100 W/mK, the delay time $\Delta D$ rapidly increases. Thus, it may be difficult to obtain preferable discharge characteristics of the PDP. Additionally, in order to prevent the PDP from overcharging, the delay time $\Delta D$ should be greater than or equal to 0 ns. Thus, the thermal conductivity of the chassis may be greater than or equal to about 10 W/mK. Thus, in order to prevent discharge delay and overcharge, the chassis' thermal conductivity may be in a range of about 10 W/mK to about 100 W/mK. Since the delay time $\Delta D$ may have relatively similar values between 50 W/mK and 100 W/mK, for plasma discharge stability, the chassis' thermal conductivity may be in a range of about 50 W/mK to about 100 W/mK.

In particular, when forming the chassis of electrolytic galvanized iron having a thermal conductivity of about 65 W/mK, a temperature measured at a portion adjacent to the TCP 271 rose by about 10°C more than when using a chassis formed of aluminum. This shows that the entire temperature of a chassis formed of a material having low thermal conductivity may be high.

Any material having a thermal conductivity in the range of about 10 W/mK to about 100 W/mK may be selected. For stiffness, cost, and other considerations, the chassis may be formed of a material containing iron. Specifically, in order to prevent corrosion, the chassis may be formed of galvanized iron. In this case, the galvanization may be performed in various ways. The chassis may be formed of a material containing electrolytic galvanized iron using an electrical method or hot dip galvanized iron considering costs and ease of manufacturing. Since the electrolytic galvanized iron may have a thermal conductivity of about 65 W/mK, it may have the proper thermal conductivity when driving the PDP at a high temperature, as well as at a low temperature. Further, in the case of hot dip galvanized iron, since the galvanized layer may be thick, it may have good anticorrosive characteristics.

Additionally, forming the chassis using galvanized iron may reduce vibration and noise of the plasma display apparatus.

Since the PDP performs a plasma discharge, vibration and noise may be generated during a discharge and be transmitted to the chassis. The vibration and noise may secondarily harmonize with electromagnetic noise characteristics of the circuits to amplify the noise. When noise exceeds an appropriate value, a method of reducing noise in the PDP should be found.

The vibration and noise caused by electromagnetic characteristics may be expressed as sound energy. In order to reduce the noise, the sound energy may be changed into another form of energy. As an example of a method for reducing noise in the PDP, a sound-absorbing material that changes sound energy into thermal energy, or the like, may be widely used. Vibration and noise generated in the PDP may be transmitted to the chassis formed of a large-density material to reduce sound energy and noise.

Generally, a surface density of a medium and transmission loss of noise according to a natural frequency may be represented as in Equation 1. As the density of the medium increases, transmission loss increases, noise transmission and vibration decrease, and noise caused by the medium also decreases.

$$TL = 18 \log mf - 44 [dB]$$

m: Surface density of medium [kg/m$^2$]

f: Frequency [Hz]

The material of the chassis was changed based on the above theoretical considerations, and noise generated in the plasma display apparatus was measured. Noise according to a type of a chassis was measured by an SPL value using a mike sensor at a location distant from front and rear sides of the plasma display apparatus by a predetermined gap, and Table 2 shows the result of comparison with a conventional chassis formed of aluminum. In this experiment, noise caused by a conventional chassis formed of aluminum was compared with the noise caused by a chassis formed of electrolytic galvanized iron according to an exemplary embodiment of the present invention.

Table 2 shows that noise may be reduced in the chassis formed of electrolytic galvanized iron. This may be because the surface density of aluminum is about $2680 kg/m^2$, and the surface density of electrolytic galvanized iron is about $7872 kg/m^2$. Hence, the surface density of electrolytic galvanized iron is relatively larger, and the noise transmission loss is larger.

Table 2

|  | Aluminum | Electrolytic galvanized iron | Remarks |
|---|---|---|---|
| Front (dB) | 26.3 | 25.3 | Average of five experimental values |
| Rear (dB) | 31.5 | 27.8 |  |

In exemplary embodiments of the present invention, the chassis may be manufactured of a variety of materials including galvanized iron. Table 3 shows thermal conductivity of three aluminum alloys that may be used in the present invention. Thermal conductivities of the three aluminum alloys are between 10 W/mK and 100 W/mK. Additionally, Table 4 shows thermal conductivity of low carbon steel, medium carbon steel, and high carbon steel that may be used in the present invention. However, an aluminum alloy and a carbon steel used in manufacturing the chassis according to the present invention are not limited to those shown in Tables 3 and 4. Additionally, the chassis may be formed of a variety of materials including stainless steel, aluminum oxide, carbon silicon, titanium, zirconium, copper, cobalt, palladium, carbon fiber, graphite fiber, glass fiber, or other like materials, and a composite material thereof.

Table 3

| Names | Thermal conductivity (W/mK) |
|---|---|
| MMCC $Al/Al_2O_3$ (Continuous Fiber Aluminum Matrix Composite) | 80 |
| MMCC $Al/Al_2O_3$ (Short Fiber Aluminum Matrix Composite) | 100 |
| MMCC $Al/Al_2O_3$ (Particulate Aluminum Matrix Composite) | 55 |

Table 4

|  | Iron content | Carbon content | Thermal conductivity |
|---|---|---|---|
| Low carbon steel | 99.11 - 99.56 | 0.14 - 0.23 | 51.9 |
| Medium carbon steel | 98.46 - 99.13 | 0.27 - 0.55 | 51.9 |
| High carbon steel | 98.38 - 98.95 | 0.55-1.03 | 46.6 |

As described above, in a plasma display apparatus according to exemplary embodiments of the present invention, a discharge delay of a PDP may be reduced.

It will be apparent to those skilled in the art that various modifications and variation can be made in the present invention without departing from the scope of the invention.

**Claims**

1. A chassis assembly for a plasma display apparatus (200), comprising
   a chassis (220) having a thermal conductivity in a range from 10 W/mK to 100 W/mK, and
   a reinforcement member (250) coupled to the chassis (220), wherein the chassis is formed of a material containing galvanized iron, and is
   **characterized in that**
   the chassis (220) and the reinforcement member (250) are formed as a single body, and
   the chassis (220) and the reinforcement member (250) are formed of a same material.

2. The chassis assembly of claim 1, wherein the thermal conductivity of the chassis (220) is in a range from 50 W/mK to 100 W/mK.

3. The chassis assembly of claim 1, wherein the galvanized iron is electrolytic galvanized iron.

4. The chassis assembly of claim 1, wherein the galvanized iron is hot dip galvanized iron.

5. The chassis assembly of claim 1, wherein a thickness of the chassis (220) is in a range from 0.8 mm to 2.0 mm.

6. A plasma display apparatus, comprising:

   a plasma display panel (210) displaying an image, using a gaseous discharge; and
   a chassis assembly according to one of claims 1-5 for supporting the plasma display panel (210).

7. The plasma display apparatus of claim 6, further comprising a thermal conductive medium (227) interposed between the plasma display panel (210) and the chassis (220).

8. The plasma display apparatus of claim 7, wherein the thermal conductive medium (227) is formed of a material containing a carbon group or silicon.

9. The plasma display apparatus of claim 7, wherein one side of the thermal conductive medium (227) is attached to the plasma display panel (210).

10. The plasma display apparatus of claim 7, wherein one side of the thermal conductive medium (227) is attached to the chassis (220).

11. The plasma display apparatus of claim 7, wherein the thermal conductive medium (227) is a single sheet.

**Patentansprüche**

1. Gestell für Plasmaanzeigetafel (200), aufweisend:

   ein Gestell (220), das eine Wärmeleitfähigkeit in einem Bereich von 10 W/mK bis 100 W/mK aufweist, und
   ein Verstärkungselement (250), das an das Gestell (220) angekoppelt ist, wobei das Gestell (220) aus einem Material ausgebildet ist, das galvanisiertes Eisen enthält, und

   **dadurch gekennzeichnet ist, dass**
   das Gestell (220) und das Verstärkungselement (250) einstückig ausgebildet sind, und
   das Gestell (220) und das Verstärkungselement (250) aus einem gleichen Material ausgebildet sind.

2. Gestell nach Anspruch 1, wobei die Wärmeleitfähigkeit des Gestells (220) in einem Bereich von 50 W/mK bis 100 W/mK liegt.

3. Gestell nach Anspruch 1, wobei das galvanisierte Eisen elektrolytisch galvanisiertes Eisen ist.

4. Gestell nach Anspruch 1, wobei das galvanisierte Eisen feuerverzinktes Eisen ist.

**5.** Gestell nach Anspruch 1, wobei eine Dicke des Gestells (220) in einem Bereich von 0,8 mm bis 2,0 mm liegt.

**6.** Plasmaanzeigetafel, aufweisend:

eine Plasmaanzeigetafel (210), die mittels einer Gasentladung ein Bild anzeigt; und
ein Gestell gemäß einem der Ansprüche 1-5 zum Tragen der Plasmaanzeigetafel (210).

**7.** Plasmaanzeigetafel nach Anspruch 6, weiterhin aufweisend ein wärmeleitfähiges Medium (227), das zwischen der Plasmaanzeigetafel (210) und dem Gestell (220) eingefügt ist.

**8.** Plasmaanzeigetafel nach Anspruch 7, wobei das wärmeleitfähige Medium (227) aus einem Material ausgebildet ist, dass eine Kohlenstoffgruppe oder Silizium enthält.

**9.** Plasmaanzeigetafel nach Anspruch 7, wobei eine Seite des wärmeleitfähigen Mediums (227) an der Plasmaanzeigetafel (210) befestigt ist.

**10.** Plasmaanzeigetafel nach Anspruch 7, wobei eine Seite des wärmeleitfähigen Mediums (227) am Gestell (220) befestigt ist.

**11.** Plasmaanzeigetafel nach Anspruch 7, wobei das wärmeleitfähige Medium (227) eine einzelne Platte ist.

**Revendications**

**1.** Assemblage de châssis pour un appareil d'affichage à plasma (200), comprenant :

un châssis (220) ayant une conductivité thermique se trouvant dans une plage allant de 10W/mK à 100W/mK, et
un élément de renforcement (250) raccordé au châssis (220),
où le châssis est formé en un matériau contenant du fer galvanisé, et il est **caractérisé en ce que** :

le châssis (220) et l'élément de renforcement (250) sont formés en un seul tenant, et
le châssis (220) et l'élément de renforcement (250) sont formés du même matériau.

**2.** Assemblage de châssis de la revendication 1, où la conductivité thermique du châssis (220) se trouve dans une plage allant de 50 W/mK à 100 W/mK.

**3.** Assemblage de châssis de la revendication 1, où le fer galvanisé est un fer galvanisé électrolytique.

**4.** Assemblage de châssis de la revendication 1, où le fer galvanisé est un fer galvanisé à chaud.

**5.** Assemblage de châssis de la revendication 1, où une épaisseur du châssis (220) se trouve dans une plage allant de 0,8 mm à 2,0 mm.

**6.** Appareil d'affichage à plasma, comprenant :

un panneau d'affichage à plasma (210) affichant une image, en utilisant une décharge gazeuse ; et
un assemblage de châssis selon l'une des revendications 1-5 pour soutenir le panneau d'affichage à plasma (210).

**7.** Appareil d'affichage à plasma de la revendication 6, comprenant en outre un milieu conducteur thermique (227) interposé entre le panneau d'affichage à plasma (210) et le châssis (220).

**8.** Appareil d'affichage à plasma de la revendication 7, où le milieu conducteur thermique (227) est formé en un matériau contenant un groupe de carbone ou du silicium.

**9.** Appareil d'affichage à plasma de la revendication 7, où un côté du milieu conducteur thermique (227) est attaché au panneau d'affichage à plasma (210).

**10.** Appareil d'affichage à plasma de la revendication 7, où un côté du milieu conducteur thermique (227) est attaché au châssis (220).

**11.** Appareil d'affichage à plasma de la revendication 7, où le milieu conducteur thermique (227) est une feuille simple.

# FIG. 1 (PRIOR ART)

# FIG. 2

# FIG. 3

# FIG. 4

# FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2002195937 A
- US 2002043607 A
- WO 2004013885 A